# EUROPEAN PATENT SPECIFICATION

(11) **EP 2 044 626 B1**
(45) Date of publication and mention of the grant of the patent: **22.07.2015**
(21) Application number: 07799114.9
(22) Date of filing: 27.06.2007
(51) Int. Cl.: H01L 23/538, H01L 21/768, H01L 23/48, H01L 23/58, H01L 21/8234, H01L 21/8238, H01L 21/764

(54) **SILICON LEVEL SOLUTION FOR MITIGATION OF SUBSTRATE NOISE**
LÖSUNG AUF SILIZIUMEBENE ZUR DÄMPFUNG VON SUBSTRATGERÄUSCH
SOLUTION À NIVEAU DE SILICIUM POUR L'ATTÉNUATION DU BRUIT DU SUBSTRAT

(30) Priority: 29.06.2006 US 479583
(43) Date of publication of application: 08.04.2009
(73) Proprietor: Intel Corporation, Santa Clara, California 95052 (US)
(72) Inventor: KAMGAING, Telesphor, Chandler, Arizona 85249 (US)
(74) Representative: Hutchinson, Glenn Stanley
(86) International application number: PCT/US2007/072296
(87) International publication number: WO 2008/003010

(56) References cited:
- EP-A2- 1 443 662
- WO-A1-97/35344
- WO-A1-2004/112138
- WO-A2-01/95389
- WO-A2-2005/002295
- JP-A- 2005 303 138
- US-A- 5 646 067
- US-A- 5 793 093
- US-A- 5 889 314
- US-A- 6 150 724
- US-B1- 6 198 168
- US-B1- 6 734 504
- SEKIGUCHI T ET AL: "Ultra small sized low noise block downconverter module", MICROWAVE SYMPOSIUM DIGEST, 1992., IEEE MTT-S INTERNATIONAL ALBUQUERQUE, NM, USA 1-5 JUNE 1992, NEW YORK, NY, USA,IEEE, US, 1 June 1992 (1992-06-01), pages 447-450, XP010062818, DOI: 10.1109/MWSYM.1992.188009 ISBN: 978-0-7803-0611-0

## Description

### TECHNICAL FIELD

Embodiments of the invention relate to mixed-signal integrated circuits. More particularly, embodiments of the invention relate to a silicon level solution that may reduce substrate-induced digital noise that can occur when digital and non-digital circuit blocks reside on the same microelectronic die.

### BACKGROUND

In general, there have been two solutions for creating wireless radio systems where digital circuitry and analog RF components reside in the same package. The first solution is to create one microelectronic die for the digital circuitry and another for the analog RF components and then connect them within a single package. The negative aspect of this solution is the high costs associated with singulation and multiple assemblies. The second solution is to have both components created in a single microelectronic die. One negative aspect of this solution concerns the interference one component can impose on the other. Embodiments of this invention address this negative aspect of the second solution. Document JP2005 303 138 teaches to provide a device and a method to control cross talk between a digital and an analog ciruit. Document WO 2005/002295 teaches reduction of noise induced in power planes due to switching of digital circuits.

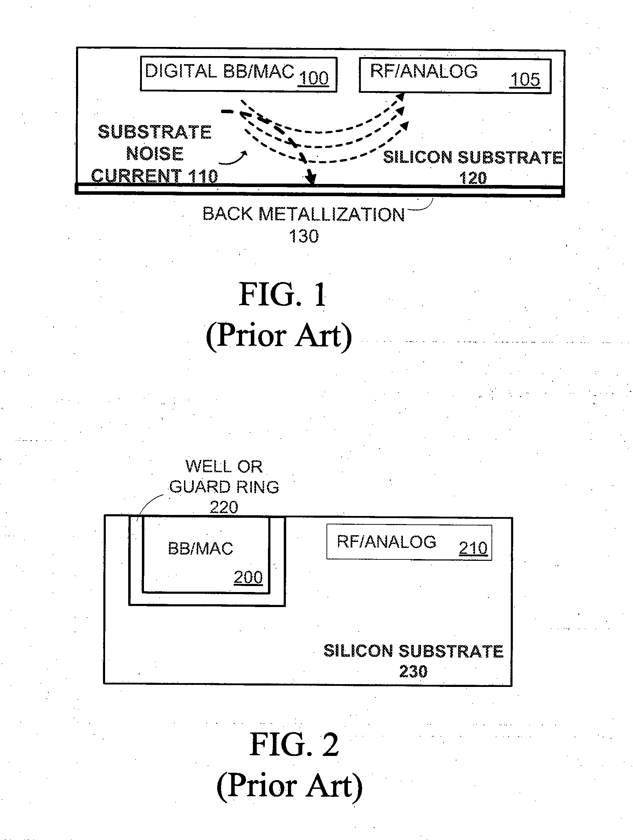

Figure 1 is a conceptual illustration of substrate noise current 110. When both digital 100 and analog 105 circuitries reside on the same microelectronic die, components can interfere with one another. For example, if several CMOS transistors switch at the same time, substrate noise current 110 is injected into the silicon substrate 120. While some current flows to the back metallization 130, the remaining current may change the overall potential of the substrate at different locations, which in turn may lead to the malfunctioning of sensitive RF/analog circuits. Other key concerns are digital-to-digital noise interference (e.g. noise generating by a digital circuit such a baseband/MAC or a processor can generate jitters in the clock signal.)

Figure 2 is a cross section of an existing solution for a single die mixed-signal device. Presently the problems created by substrate noise current are solved either at the package level through the aforementioned process of combining separate microelectronic dice, or at the chip level through the use of deep wells 220 (either n-type or p-type). These wells 220 are regions around circuitry doped inversely (n or p) to create an inherent pn junction that acts as a diode and prevents signal transmission from, in this example, digital circuitry 200 to the analog circuitry 210 when the well 220 is properly reversed-biased. This chip level solution requires constant biasing of the well junction 220 in order to achieve reverse biasing. This chip level solution also requires both power to be supplied to the well 220 to activate it and volume within the substrate 230 to accommodate the well 220. Furthermore, at very high frequencies the parasitic capacitance of the junction may continue to provide a conductive path to the substrate noise current independent of the reverse bias voltage.

### BRIEF DESCRIPTION OF THE DRAWINGS

Embodiments of the invention are illustrated by way of example, and not by way of limitation, in the figures of the accompanying drawings in which like reference numerals refer to similar elements.
**Figure 1** is a cross section of one embodiment of a single chip wireless radio system illustrating substrate noise current.
**Figure 2** is a cross section of a well junction.
**Figure 3** is a cross-section illustration of one embodiment of a microelectronic die with a photoresist mask.
**Figure 4** is a cross-section illustration of one embodiment of a microelectronic die with hollow isolation vias.
**Figure 5** is a cross-section illustration of one embodiment of a microelectronic die with metal-filled isolation vias.
**Figure 6** is a cross-section illustration of one embodiment of a microelectronic die with metal-lined isolation vias.
**Figure 7** illustrates the operation of one embodiment of a microelectronic die from a side-view perspective.
**Figure 8** is a top view (with silicon backend not shown) of one embodiment of a microelectronic die containing a plurality of isolation vias with a staggered row depth of two.
**Figure 9** is a cross section illustration of one embodiment of a microelectronic die containing isolation vias.
**Figure 10** is a cross section illustration of one embodiment of a microelectronic die containing hollow isolation vias with backend interconnectivity attached.
**Figure 11** is a block diagram of one embodiment of a system with isolation vias between circuit blocks.

### DETAILED DESCRIPTION

The invention provides an apparatus as recited in claim 1, a system as recited in claim 8, and a method as recited in claim 9.

In the following description, numerous specific details are set forth. However, embodiments of the invention may be practiced without these specific details. In other instances well-known circuits, structures and techniques have not been shown in detail in order not to obscure the understanding of this description.

The techniques described herein may reduce the substrate noise current that exists when digital and analog components reside on the same microelectronic die. Single or multiple rows of isolation vias may form current barriers between the individual circuit blocks (e.g., between switching CMOS circuitry and analog RF circuitry). The isolation vias may be hollow, lined or filled with a conductive or nonconductive material. Substrate current is redirected more efficiently when the isolation vias are lined or filled with a conductive metal; however, this process incurs the expense of more production steps. In the description that follows, isolation vias are generally depicted as cylindrical, however, the isolation vias may be any shape (e.g., square, elliptical) or size.

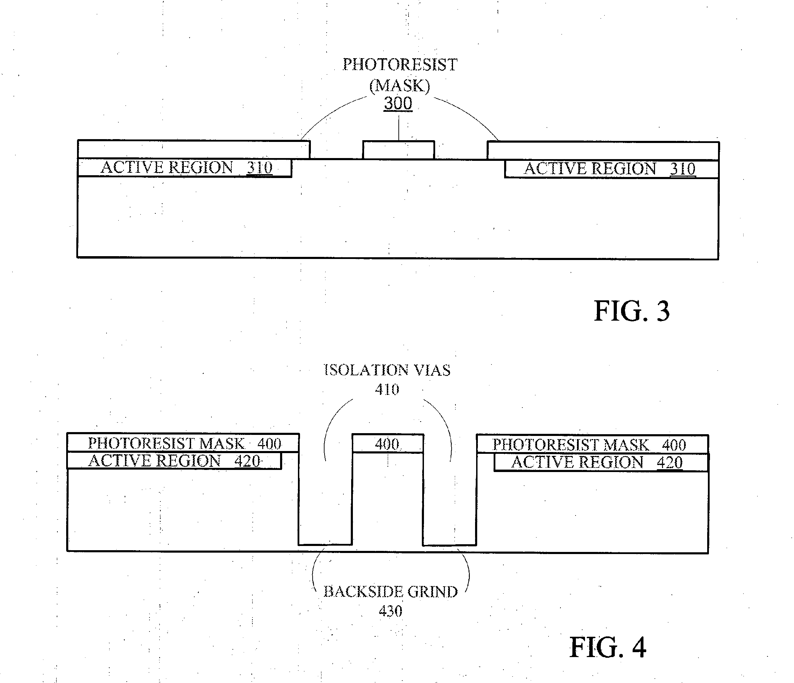

**Figure 3** is a cross-section illustration of one embodiment of a microelectronic die with a photoresist mask 300 configured for the creation of isolation vias between active regions 310. Figure 3 illustrates the process for creation of the isolation vias after the active regions 310 of the microelectronic die are manufactured using any process known in the art and may include either digital or analog circuitry. The microelectronic die may be coated with a photoresist mask 300, forming a pattern layer wherein openings form isolation vias and active regions are covered. Any technique known in the art to deposit (or otherwise apply) the photoresist 300 may be utilized. Also, any technique known in the art to expose the via regions may be utilized.

**Figure 4** is a cross-section illustration of one embodiment of a microelectronic die with hollow isolation vias 410 etched partially through the silicon. Isolation vias may be created by areas of the microelectronic die exposed from the photoresist mask 400 through the use of, for example, "wet etching" or "dry etching." Isolation vias 410 between the active regions 420 may be formed once the etching is complete. The microelectronic die may be etched completely through the silicon, or partially through, where the remaining portions of the die 430 may be reduced via backside surface grinding.

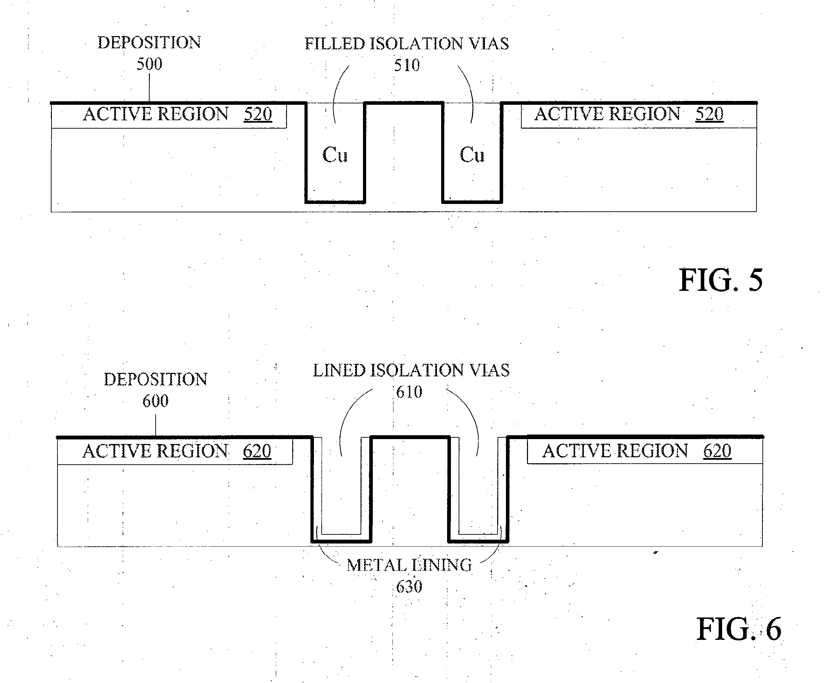

**Figure 5** is a cross-section illustration of one embodiment of a microelectronic die with metal-filled isolation vias 510. The example in Figure 5 illustrates the method of subjecting the microelectronic die to a deposition process 500, which may be any process that grows, coats, or otherwise transfers a material onto the microelectronic die. Any deposition process known in the art may be used. After the deposition process the isolation vias 510 between the active regions 520 may be filled with conductive metal (e.g. copper, aluminum). Any technique known in the art suitable for metal deposition may be used.

**Figure 6** is a cross section of one of a microelectronic die with metal-lined isolation vias. The example in Figure 6 illustrates the method of subjecting the microelectronic die to a deposition process 600, which may be any process that grows, coats, or otherwise transfers a material onto the microelectronic die. After the deposition process the isolation vias 610 between the active regions 620 may be electroplated with conductive metal (e.g. copper, aluminum) walls 630. Any technique known in the art for lining via walls and/or electroplating may be utilized.

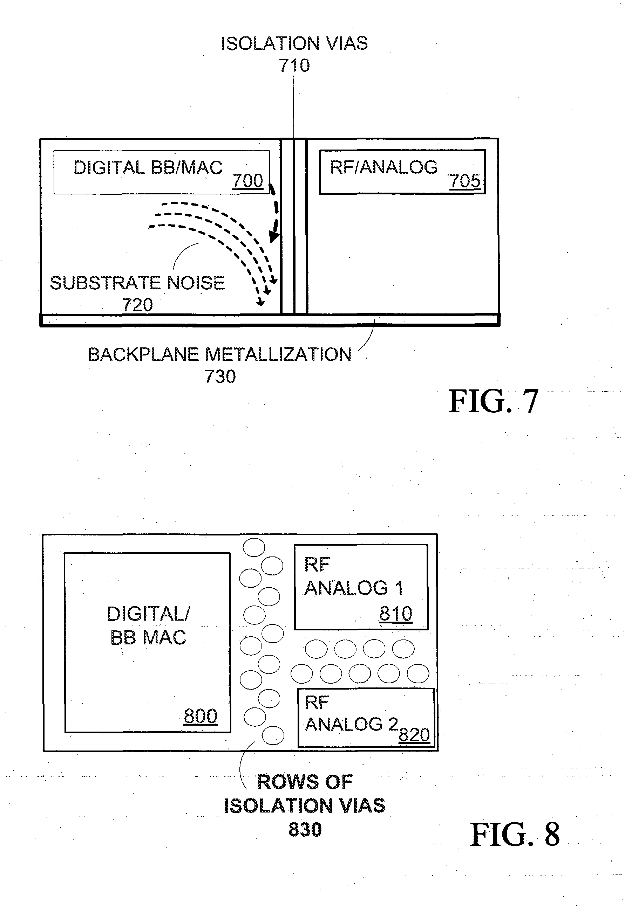

**Figure 7** illustrates the operation of one embodiment of a microelectronic die having isolation vias from a side-view perspective. The isolation vias 710 are positioned between digital circuitry 700 and analog circuitry 705 and may be connected to backplane metallization 730, which is typically used as ground for the microelectronic die. Substrate noise 720 generated by the digital circuitry is redirected to the ground plane so as to not affect analog circuitry 705. In the absence of a backplane metallization 730 (i.e. thinned microelectronic die) isolation vias 710 may be tied together through a metal strip, which may be connected to ground.

In one embodiment, a single row of isolation vias will be sufficient to provide isolation. In another embodiment, staggered rows, at least two isolation vias deep, may create a barrier with no direct path for the current to flow between circuitries.

**Figure 8** is a top view (with silicon backend not shown) of one embodiment of a microelectronic die containing a plurality of isolation vias 830 with a staggered row depth of two. Figure 8 illustrates how staggered rows 830 can prevent a direct current path between circuitries 800, 810 and 820. In the example of Figure 8, each circuit block (e.g., 800, 810, 820) facing another circuit block may have isolation vias between the circuit blocks.

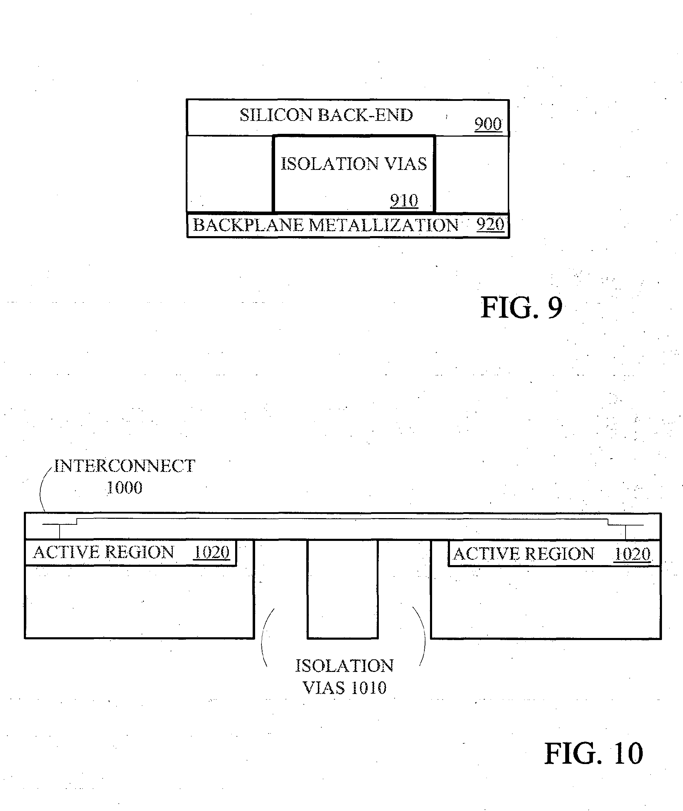

The height of the isolation vias may be through the silicon only so as to not affect the back-end where chip interconnectivity exists. This particular embodiment will not affect connectivity between the digital and analog circuitry. Figure 9 is an illustration of one embodiment of a microelectronic die containing isolation vias 910 that are created through the silicon only, between the silicon back-end 900 and the backplane metallization 920.

**Figure 10** is a cross section of one embodiment of a microelectronic die containing hollow isolation vias 1010 with backend interconnectivity 1000 layers. The example in Figure 10 illustrates how the connectivity 1000 to the active regions 1020 may be isolated and unaffected by the presence of isolation vias 1010.

The isolation vias are placed periodically, to provide an electromagnetic band-gap structure. This structure may provide an additional electromagnetic band at high frequencies. This band-gap structure may be suitable for high frequency applications (e.g. radar applications that operate at 77 GHz) for which the present state of the art is not suitable.

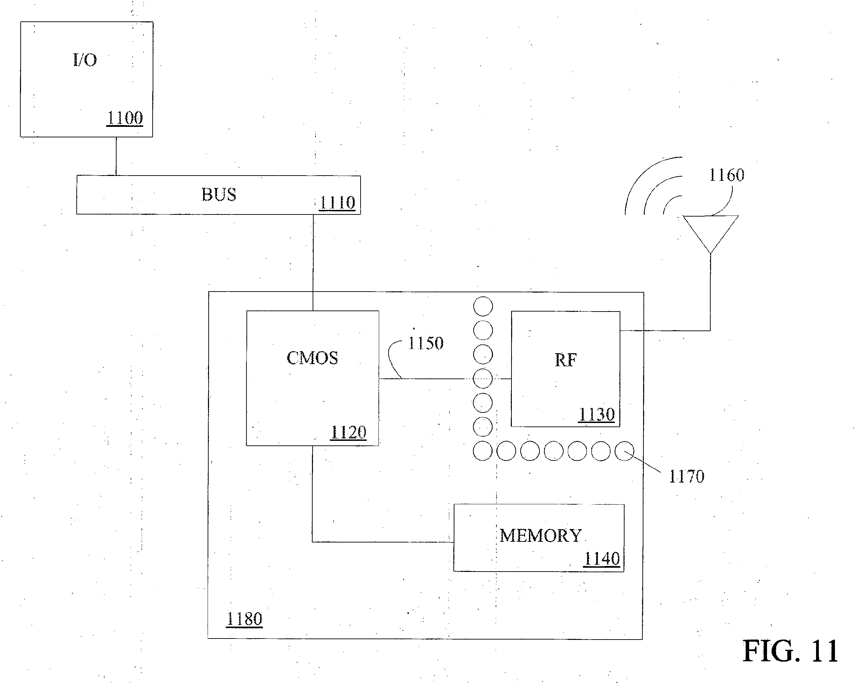

**Figure 11** is a block diagram of one embodiment of a system with isolation vias 1170 between circuit blocks 1120 and 1130. The example in Figure 11 illustrates a system containing an I/O mechanism 1100, a bus 1110 and a microelectronic die 1180 connected to an antenna 1160. Antenna 1160 may be any type of antenna, for example, a substantially omnidirectional antenna, or antenna 1160 may represent an array of antennae. The RF component 1130 is isolated from CMOS circuitry 1120 and a memory component 1140 by a row of isolation vias 1170. The connectivity 1150 between the CMOS circuitry 1120 and the RF component 1130 runs on a plane that is separate from the isolation vias 1170.

Reference in the specification to "one embodiment" or "an embodiment" means that a particular feature, structure or characteristic described in connection with the embodiment is included in at least one embodiment of the invention. The appearances of the phrase "in one embodiment" in various places in the specification are not necessarily all referring to the same embodiment.

## Claims

1. An apparatus comprising:
digital functional circuitry (700) on a first portion of a microelectronic die; and
analog radio frequency (RF) circuitry (705) on a second portion of the microelectronic die; and
a plurality of isolation vias (410,510,610,710,810,830,910,1010) disposed between the digital functional circuitry and the analog RF circuitry, wherein the plurality of isolation vias are created through a silicon substrate of the microelectronic die between a silicon backend (300) and a backplane metallization (730,920) so as to be isolated from the interconnectivity between the digital functional circuitry and the analog RF circuitry; **characterized in that**
the plurality of isolation vias are placed periodically to provide an electromagnetic band-gap structure.

2. The apparatus of claim 1 wherein the digital functional circuitry comprises complementary metal oxide semiconductor (CMOS) circuitry; or wherein the digital functional circuitry comprises media access control (MAC) circuitry.

3. The apparatus of claim 1, wherein the plurality of isolation vias are filled with metal; or
wherein the plurality of isolation vias are lined with metal (630).

4. The apparatus of claim 1, wherein the analog RF circuitry comprises radar frequency circuitry: or
wherein the electromagnetic band-gap structure provides current isolation up to 77 GHz.

5. The apparatus of claim 1 wherein the analog RF circuitry comprises wireless local area network (WLAN) frequency circuitry.

6. The apparatus of claim 1 wherein the analog RF circuitry comprises Worldwide Interoperability for Microwave Access (WiMAX) frequency circuitry.

7. The apparatus of claim 1 wherein the plurality of isolation vias comprise two rows of isolation vias (830) where the first row is physically offset with respect to the second row, preferably, wherein a distance between isolation vias of the first row is approximately equal to a width of isolation vias of the second row.

8. A system comprising:
an apparatus as claimed in any preceding claim.

9. A method comprising:
forming active regions on a microelectronic die wherein at least one region is configured for digital circuitry (700) and at least one region is configured for analog radio frequency (RF) circuitry (705),
forming a plurality of isolation vias (410,510,610,710,810,830,910,1010) between digital functional circuitry and analog RF circuitry, wherein the plurality of isolation vias are created through a silicon substrate of the microelectronic die between a silicon backend (900) and a backplane metallization (730,920) so as to be isolated from the interconnectivity between the digital functional circuitry and the analog RF circuitry; and **characterized in that**
the plurality of isolation vias are placed periodically to provide an electromagnetic barnd-gap structure.

10. The method of claim 9 wherein the digital functional circuitry comprises complementary metal oxide semiconductor (CMOS) circuitry.

11. The method of claim 9 wherein the analog RF circuitry comprises wireless local area network (WLAN) frequency circuitry.

12. The method of claim 9 wherein the analog RF circuitry comprises radar frequency circuitry.

13. The method of claim 9 wherein the analog RF circuitry comprises Worldwide Interoperability for Microwave Access (WiMAX) frequency circuitry.

14. The method of claim 9 wherein the plurality of isolation vias are filled with metal (510).

15. The method of claim 9 wherein the plurality of isolation vias are lined with metal (630).

## Patentansprüche

1. Vorrichtung, umfassend:
digitale Funktionsschaltungsanordnung (700) auf einem ersten Abschnitt eines mikroelektronischen Chips; und
analoge Hochfrequenz (HF)-Schaltungsanordnung (705) auf einem zweiten Abschnitt des mikroelektronischen Chips; und
eine Mehrzahl von Trennkontaktlöchern (410, 510, 610, 710, 810, 830, 910, 1010), die zwischen der digitalen Funktionsschaltungsanordnung und der analogen HF-Schaltungsordnung angeordnet sind, wobei die Mehrzahl von Trennkontaktlöchern zwischen einer Silicium-Ausgangsseite (900) und einer Rückwandmetallisierung (730, 920) so durch ein Siliciumsubstrat des mikroelektronischen Chips ausgebildet ist, dass sie von der Interkonnektivität zwischen der digitalen Funktionsschaltungsanordnung und der analogen HF-Schaltungsanordnung getrennt ist; **dadurch gekennzeichnet, dass**
die Mehrzahl von Trennkontaktlöchern periodisch angeordnet ist, um eine elektromagnetische Bandabstandsstruktur bereitzustellen.

2. Vorrichtung nach Anspruch 1, wobei die digitale Funktionsschaltungsanordnung CMOS (komplementäre Metalloxidhalbleiter)-Schaltungsanordnung umfasst; oder wobei die digitale Funktionsschaltungsanordnung MAC (Medienzugriffssteuerung)-Schaltungsanordnung umfasst.

3. Vorrichtung nach Anspruch 1, wobei die Mehrzahl von Trennkontaktlöchern mit Metall gefüllt ist; oder
wobei die Mehrzahl von Trennkontaktlöchern mit Metall ausgekleidet ist (630).

4. Vorrichtung nach Anspruch 1, wobei die analoge HF-Schaltungsanordnung Radarfrequenzschaltungsanordnung umfasst; oder
wobei die elektromagnetische Bandabstandsstruktur Stromtrennung bis zu 77 GHz bereitstellt.

5. Vorrichtung nach Anspruch 1, wobei die analoge HF-Schaltungsanordnung WLAN (drahtloses lokales Netz)-Frequenzschaltungsanordnung umfasst.

6. Vorrichtung nach Anspruch 1, wobei die analoge HF-Schaltungsanordnung WiMAX (weltweite Interoperabilität für Mikrowellenzugang)-Frequenzschaltungsanordnung umfasst.

7. Vorrichtung nach Anspruch 1, wobei die Mehrzahl von Trennkontaktlöchern zwei Reihen von Trennkontaktlöchern (830) umfasst, wobei die erste Reihe in Bezug auf die zweite Reihe vorzugsweise physisch versetzt ist, wobei ein Abstand zwischen Trennkontaktlöchern der ersten Reihe ungefähr gleich einer Breite von Trennkontaktlöchern in der zweiten Reihe ist.

8. System, umfassend:
eine Vorrichtung nach einem der vorhergehenden Ansprüche.

9. Verfahren, umfassend:
Bilden von aktiven Regionen auf einem mikroelektronischen Chip, wobei mindestens eine Region für digitale Funktionsschaltungsanordnung (700) ausgelegt ist, und mindestens eine Region für analoge Hochfrequenz (HF)-Schaltungsanordnung (705) ausgelegt ist;
Bilden einer Mehrzahl von Trennkontaktlöchern (410, 510, 610, 710, 810, 830, 910, 1010) zwischen der digitalen Funktionsschaltungsanordnung und der analogen HF-Schaltungsordnung, wobei die Mehrzahl von Isolationskontaktlöchern zwischen einer Silicium-Ausgangsseite (900) und einer Rückwandmetallisierung (730, 920) so durch ein Siliciumsubstrat des mikroelektronischen Chips ausgebildet ist, dass sie von der Interkonnektivität zwischen der digitalen Funktionsschaltungsanordnung und der analogen HF-Schaltungsanordnung getrennt ist; und **dadurch gekennzeichnet, dass**
die Mehrzahl von Trennkontaktlöchern periodisch angeordnet ist, um eine elektromagnetische Bandabstandsstruktur bereitzustellen.

10. Verfahren nach Anspruch 9, wobei die digitale Funktionsschaltungsanordnung CMOS (komplementäre Metalloxidhalbleiter)-Schaltungsanordnung umfasst.

11. Verfahren nach Anspruch 9, wobei die analoge HF-Schaltungsanordnung WLAN (drahtloses lokales Netz)-Frequenzschaltungsanordnung umfasst.

12. Verfahren nach Anspruch 9, wobei die analoge HF-Schaltungsanordnung Radarfrequenzschaltungsanordnung umfasst.

13. Verfahren nach Anspruch 9, wobei die analoge HF-Schaltungsanordnung WiMAX (weltweite Interoperabilität für Mikrowellenzugang)-Frequenzschaltungsanordnung umfasst.

14. Verfahren nach Anspruch 9, wobei die Mehrzahl von Trennkontaktlöchern mit Metall gefüllt wird (510).

15. Verfahren nach Anspruch 9, wobei die Mehrzahl von Trennkontaktlöchern mit Metall ausgekleidet wird (630).

## Revendications

1. Appareil, comprenant :
une circuiterie fonctionnelle numérique (700) sur une première partie d'une puce microélectronique ; et
une circuiterie radiofréquence (RF) analogique (705) sur une deuxième partie de la puce microélectronique ; et
une pluralité de vias d'isolation (410, 510, 610, 710, 810, 830, 910, 1010) disposée entre la circuiterie fonctionnelle numérique et la circuiterie RF analogique, laquelle pluralité de vias d'isolation est ménagée à travers un substrat au silicium de la puce microélectronique entre une interconnexion en back-end au silicium (900) et une métallisation de fond de panier (730, 920) de manière à être isolée de l'interconnectivité entre la circuiterie fonctionnelle numérique et la circuiterie RF analogique ; l'appareil étant **caractérisé en ce que**
la pluralité de vias d'isolation est placée périodiquement afin de procurer une structure à bande interdite électromagnétique.

2. Appareil selon la revendication 1, dans lequel la circuiterie fonctionnelle numérique comprend une circuiterie à semi-conducteur à l'oxyde de métal complémentaire (CMOS) ; ou dans lequel la circuiterie fonctionnelle numérique comprend une circuiterie de commande d'accès aux supports (MAC).

3. Appareil selon la revendication 1, dans lequel la pluralité de vias d'isolation est remplie de métal ; ou
dans lequel la pluralité de vias d'isolation est revêtue intérieurement de métal (630).

4. Appareil selon la revendication 1, dans lequel la circuiterie RF analogique comprend une circuiterie à fréquence radar ; ou
dans lequel la structure à bande interdite électromagnétique procure une isolation du courant à hauteur de 77 GHz.

5. Appareil selon la revendication 1, dans lequel la circuiterie RF analogique comprend une circuiterie à fréquence de réseau local sans fil (WLAN).

6. Appareil selon la revendication 1, dans lequel la circuiterie RF analogique comprend une circuiterie à fréquence à interopérabilité mondiale pour accès hyperfréquence (WiMAX).

7. Appareil selon la revendication 1, dans lequel la pluralité de vias d'isolation comprend deux rangées de vias d'isolation (830), la première rangée étant physiquement décalée par rapport à la deuxième rangée, de préférence une distance séparant les vias d'isolation de la première rangée étant à peu près égale à une largeur des vias d'isolation dans la deuxième rangée.

8. Système, comprenant :
un appareil selon l'une quelconque des revendications précédentes.

9. Procédé, comprenant les étapes consistant à :
former des régions actives sur une puce microélectronique, au moins une région étant configurée pour une circuiterie fonctionnelle numérique (700) et au moins une région étant configurée pour une circuiterie radiofréquence (RF) analogique (705) ;
former une pluralité de vias d'isolation (410, 510, 610, 710, 810, 830, 910, 1010) entre la circuiterie fonctionnelle numérique et la circuiterie RF analogique, laquelle pluralité de vias d'isolation est ménagée à travers un substrat au silicium de la puce microélectronique entre une interconnexion en back-end au silicium (900) et une métallisation de fond de panier (730, 920) de manière à être isolée de l'interconnectivité entre la circuiterie fonctionnelle numérique et la circuiterie RF analogique ; et le procédé étant **caractérisé en ce que**
la pluralité de vias d'isolation est placée périodiquement afin de procurer une structure à bande interdite électromagnétique.

10. Procédé selon la revendication 9, dans lequel la circuiterie fonctionnelle numérique comprend une circuiterie à semi-conducteur à l'oxyde de métal complémentaire (CMOS).

11. Procédé selon la revendication 9, dans lequel la circuiterie RF analogique comprend une circuiterie à fréquence de réseau local sans fil (WLAN).

12. Procédé selon la revendication 9, dans lequel la circuiterie RF analogique comprend une circuiterie à fréquence radar.

13. Procédé selon la revendication 9, dans lequel la circuiterie RF analogique comprend une circuiterie à fréquence à interopérabilité mondiale pour accès hyperfréquence (WiMAX).

14. Procédé selon la revendication 9, dans lequel la pluralité de vias d'isolation est remplie de métal (510).

15. Procédé selon la revendication 9, dans lequel la pluralité de vias d'isolation est revêtue intérieurement de métal (630).
